(19)

Europäisches
Patentamt
European
Patent Office
Office européen
des brevets

(11) **EP 2 629 110 A1**

(12) **EUROPEAN PATENT APPLICATION**

(43) Date of publication:
**21.08.2013 Bulletin 2013/34**

(51) Int Cl.:
**G01R 33/30** (2006.01)     **G01R 33/48** (2006.01)
**G01R 33/56** (2006.01)     **G01R 33/563** (2006.01)

(21) Application number: **12305190.6**

(22) Date of filing: **20.02.2012**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicants:
• **Université de Rennes I
35065 Rennes Cedex (FR)**
• **Chu De Rennes
35033 Rennes Cedex 9 (FR)**
• **Centre Eugène Marquis
35042 Rennes Cedex (FR)**

(72) Inventors:
• **Saint-Jalmes, Hervé
35000 Rennes (FR)**
• **Duvauferrier, Régis
35430 Saint Suliac (FR)**
• **Bouk'hil, Hind
35000 Rennes (FR)**

(74) Representative: **Thévenet, Jean-Bruno et al
Cabinet Beau de Loménie
158, rue de l'Université
75340 Paris Cédex 07 (FR)**

(54) **Improvements in diffusion-weighted magnetic resonance imaging**

(57)    The apparent diffusion coefficient of biological tissue can be estimated using weighted-diffusion measurement data produced for a known b-value in combination with baseline measurement data, such as STIR data, T2-weighted data, etc. produced by a magnetic resonance imaging apparatus (3), when at least one reference sample (5) of known diffusion properties is imaged at the same time as the tissue. The known diffusion values can be temperature-adjusted based on a temperature measurement made by evaluating, in MRI image data, the length of a liquid column in an MRI thermometer (30) that includes a relatively large reservoir (33) and a measurement tube (31) of cross-section 1 millimetre or larger.

**FIG. 4**

S1 Position subject and reference samples in bore of MRI apparatus

S2 Apply STIR measurement sequence and acquire STIR data for subject + reference samples

S3 Apply diffusion-weighted measurement sequence using known b-value and acquire diffusion-weighted data

S4 Using STIR and diffusion-weighted measurement data for reference samples, estimate $R_{DS0}$

S5 Use estimated $R_{DS0}$ and equation (6) to calculate ADC values for tissue in subject S using STIR and diffusion-weighted measurement data for the tissue.

EP 2 629 110 A1

**Description**

Field Of The Invention

The present invention relates to the field of diffusion weighted nuclear magnetic resonance imaging (DWMRI) and, notably, to new techniques for determining the diffusion coefficient of biological tissue, and for measuring temperature in MRI apparatus.

Background Art

Nowadays, nuclear magnetic resonance imaging is widespread as a technique for producing medically-relevant images of the human (or animal) body. The operating conditions of the nuclear magnetic resonance imaging apparatus (MRI apparatus) can be controlled in different ways in order to produce NMR images that map how different parameters vary in biological tissue and to generate images in different planes. Thus, for example, operating conditions can be adjusted so as to produce mappings illustrating parameters such as the T1 or T2 relaxation time of the imaged biological tissues, and to produce images in the sagittal, coronal and transverse planes.

During a single session when a patient is positioned in the bore of the MRI apparatus, it is conventional to take a series of measurements of different kinds. Protocols have been developed indicating which measurements should be taken in order to produce a set of images that is useful to a clinician when diagnosing or monitoring a particular medical condition. These days, during a given MRI measurement session it is common to acquire, in addition to a sagittal T1 image, a coronal STIR image (STIR stands for Short inversion Time Inversion Recovery); in view of the fact that the influence of fat and other materials having short T1 relaxation times is reduced in a STIR image.

Diffusion MRI is a known technique for evaluating how the diffusion of a metabolite (generally water) varies in biological tissue. Diffusion MRI is attracting interest because its signal depends on the microscopic mobility of water (Brownian motion) which, in turn, depends on the local environment and can indicate cell and micro vessel density, parameters that can be markers of tumour aggressiveness. The Apparent Diffusion Coefficient (ADC) is a parameter that quantifies the average rate of diffusion of water or another metabolite in a given volume of imaged biological tissue. Diffusion-weighted MRI generates a map of the Apparent Diffusion Coefficient (ADC) of the metabolite in biological tissue. More precisely, it could be said that ADC evaluation measures the diffusion of a nucleus of interest, for example the diffusion of the hydrogen nucleus (present in the water, fat, etc. present in the imaged tissue).

The present invention shall be described in relation to measurement of the ADC of water in biological tissues. However, it is to be understood that the principles of the invention can be applied for measuring the ADC of other metabolites. In general, the diffusion measurement signal tends to be weak, so ADC tends to be measured for substances having a large number of protons (e.g. water, fatty acids and the like).

In diffusion-weighted MRI, additional controlled magnetic field pulses are applied to the test volume in order to give a diffusion weighting to the measured signal. The applied conditions can be characterized by a b-value, given by:

$$b = |g|^2 \gamma^2 \delta^2 (\Delta - {}^{\delta}\!/_3) \qquad (1)$$

where lgl is the strength of the diffusion gradient pulse, y is the gyromagnetic ratio of the proton, $\delta$ is the duration of the pulse, and $\Delta$ is the time between two pulses. The signal $S_{DIFF}$ that is measured during diffusion-weighted MRI can be expressed, as follows (in the case where the diffusion-weighted sequence incorporates an inversion pulse TI):

$$S_{DIFF} = S_{0\,DIFF} (1 - E^{-TI/T1} (2 - E^{-TR/T1})) E^{-TE/T2} E^{-b \cdot ADC} \qquad (2)$$

or as follows (in the case where the diffisuion-weighted sequence does not include an inversion pulse) where $S_{0DIFF}$ is constant for a given diffusion-weighted image (and depends on operating conditions such as the field of view, gain in the reception channel, etc.), TI is the inversion time (usually set by the user to a value close to 170 milliseconds when the main applied magnetic field is 1.5 tesla), TR is the repetition time (usually set by the user to a relatively long time period, of the order of 10 seconds), TE is the echo time (typically in the range of 50-100 ms, approximately), T1 and T2 are the T1 and T2 relaxation times of the tissue whose properties are being measured, b represents the above-mentioned b-value, and ADC is the Apparent Diffusion Coefficient to be evaluated.

The skilled person will readily understand that the diffusion-weighted sequence may be varied in other details (besides the incorporation or not of an inversion pulse), notably encoding through echo planar imaging or turbo spin echo.

Conventionally the Apparent Diffusion Coefficient is mapped by taking two (or more) diffusion-weighted sequences of measurements, using different b-values for each sequence (obviously, if an inversion pulse is applied in one of the sequences, notably to decrease the signal from fatty tissues, then an inversion pulse is also applied in the other diffusion-weighted sequence(s)). In other words, when $S1_{DIFF}(x,y,z)$ is the signal measured at a point $(x,y,z)$ when a first b-value b1 is applied, and $S2_{DIFF}(x,y,z)$ is the measurement made at the same point when a second b-value b2 is applied, then:

$$ADC(x,y,z) = \ln\,[S2_{DIFF}(x,y,z)\,/\,S1_{DIFF}(x,y,z)]\,/\,(b1\text{-}b2) \qquad (3)$$

Because equation (3) makes use of a ratio between two $S_{DIFF}$ measurements, the constant $S_{0DIFF}$ (see equations (2) and (2a) above) cancels out. Typically one sequence of measurements is taken for b=0 (i.e. no applied diffusion-weighting pulses).

If an MRI measurement protocol includes the taking of measurements to generate a diffusion-weighted image in addition to the taking of measurements for generation of other images, then the duration of the whole session can become as long as one hour notably because, in the case of whole body imaging, where it is necessary to generate images of a subject's body from the top of the head to (at least) the pelvis, diffusion-weighted MRI typically involves six measurement stages for each b-value top ensure that the whole body is covered. Inherently this duration is undesirably long. Moreover, because the evaluation of ADC is made using a point-by-point comparison between measurement data acquired using different b-values, it is important for the subject to remain completely still between measurements. This can be extremely difficult if the measurement period is long, especially for subjects who are ill or elderly.

Moreover, there are situations in which it can be useful to know the temperature in the bore of the MRI apparatus (this temperature typically varies between 18 and 27°C). This could be done by use of a thermometer to check temperature in the bore of the MRI apparatus just after the measurement data has been collected. However, such a technique is not particularly accurate. Various methods have been proposed for measuring the temperature of body tissue in an MRI apparatus by generating MR measurement data on the tissue (or a phantom) and performing calculations on the measurement data. However, this is computationally intensive and in most cases it only enables changes in temperature to be evaluated, not the absolute temperature.

The present invention has been made in consideration of the above-identified problems.

Summary of the Invention

The present inventors have determined that it is possible to estimate the apparent diffusion coefficient (ADC) of water or another metabolite (or, more generally, a nucleus of interest) in biological tissue using MRI apparatus, to a reasonable degree of accuracy, by acquiring only one diffusion-weighted image and combining the acquired diffusion-weighted data with data relating to an image having the same type of acquisition (e.g. a STIR image, a T2-weighted image, etc.), taking into account reference signals that are measured for reference samples which have known diffusion properties and are positioned in the measurement zone so as to be visible in the images whose data is combined.

More particularly, according to a first aspect the invention provides a method of evaluating the apparent diffusion coefficient of a region in biological tissue, the apparent diffusion coefficient being indicative of the rate of diffusion of a predetermined nucleus of interest in said region, the method comprising the steps of:

introducing into the bore of a magnetic resonance apparatus: said biological tissue, and at least one reference sample having a known diffusion coefficient of said predetermined nucleus of interest;
generating baseline measurement data by applying a nuclear magnetic resonance measurement sequence to said region in the biological tissue and to the reference sample(s);
generating diffusion-weighted measurement data by applying a diffusion-weighted nuclear magnetic resonance measurement sequence having a known non-zero b value to said region in the biological tissue and to the reference sample(s);
estimating a first ratio based on the ratio between diffusion-weighted measurement data measured for said reference sample(s) and baseline measurement data measured for said reference sample(s), on the b-value applied during generation of the diffusion-weighted measurement data, and on the known diffusion coefficient of the reference substance; and
calculating the apparent diffusion coefficient of said region in biological tissue based on the ratio between diffusion-weighted measurement data measured for said region and baseline measurement data measured for said region, on the b-value applied during generation of the diffusion-weighted measurement data, and on the estimated first ratio.

Because the invention makes use of baseline measurement data relating to an MR image that is already being acquired as part of the measurement protocol, it is possible to evaluate ADC values even when diffusion-weighted image data is generated only in respect of a single b-value. This enables the measurement protocol to include measurement of ADC without unduly extending the duration of the measurement session. In particular, the duration of the measurement session can be kept down to 45 minutes, rather than the 60 minutes that would be required if two diffusion-weighted sequences of measurements, using different b-values, were to be taken.

The method is more robust if at least two reference samples having known and different diffusion coefficients of the predetermined liquid are introduced into the bore of the MRI apparatus with the biological tissue, and baseline measurement data and diffusion-weighted measurement data is generated for each of the two or more reference samples. Individual preliminary estimates can then be made of the first ratio, based on measurement data for each of the reference samples, and the estimate of the first ratio is produced by combining the individual preliminary estimates.

The baseline measurement data may be generated by applying various different types of measurement sequences, for example, a short inversion time inversion recovery (STIR) measurement sequence, a T2-weighted measurement sequence, a simple spin echo T1 sequence (provided that there is enough gradient amplitude to accommodate for the short TE), or a turbo spin echo (TSE) sequence.

As indicated above, the baseline measurement data and diffusion-weighted measurement data that is combined should have the same type of acquisition, that is the baseline measurement data and diffusion-weighted measurement data that is combined should have the same features (e.g. if an inversion pulse, for fat suppression, is included in the diffusion-weighted sequence then an inversion pulse should be incorporated into the baseline measurement sequence also; if frequency selective pulses are used in the diffusion-weighted sequence then such pulses should be used also in the baseline measurement sequence, etc.). It is also desired for the values of control parameters including the echo time (TE) and repetition time (TR) (and, when applicable, the inversion time (TI)) to be set substantially the same in the step of generating baseline measurement data as in the step of generating diffusion-weighted measurement data. Preferably the baseline measurement data and diffusion-weighted measurement data that is combined should have approximately the same resolution in terms of contrast.

Because it is necessary for the baseline sequence and the diffusion-weighted sequence to have substantially the same echo times, it is advantageous to use T2-weighted sequences for the baseline measurement data in the case where the diffusion-weighted sequence corresponds to a relatively large b value, and requires a relatively long echo time. However, if the b value used in the diffusion-weighted sequence is relatively lower, corresponding to a lower echo time (e.g. for perfusion measurement), then the baseline measurement sequence may be a T1-weighted or proton-density-weighted image).

The ADC values evaluated by the above-described method are more accurate if the diffusion coefficient values of the reference sample(s) is/are adjusted based on the temperature, and the temperature-adjusted values are used in estimating the first ratio.

Implementation of the method is facilitated in the case where the reference sample(s) is/are contained in a guide structure that includes a portion that is configured to fit between a body part of the subject and a table of the MRI apparatus. This ensures an appropriate positioning of the sample(s) relative to the subject during the acquisition of measurement data.

The first aspect of the invention further provides a guide structure adapted for use in the above-described method, notably a guide structure comprising: at least one compartment for receiving a reference sample having a known diffusion coefficient of a predetermined liquid, and a positioning portion configured to lie between a body part of a human subject and a table of an MRI apparatus on which the subject lies, thereby to position the reference sample(s) relative to the subject (S).

According to a second aspect the invention provides an MRI thermometer comprising: a reservoir in communication with a measurement tube, the measurement tube being made of a material that is substantially transparent in MRI images; and a liquid provided at least in the reservoir and configured to expand along the measurement tube as temperature increases, the liquid being visible in nuclear magnetic resonance (NMR) images; wherein: the internal cross-section of the measurement tube is 1 mm or greater, and there is a difference in temperature coefficient of expansion between the liquid and the material(s) of the reservoir and measurement tube, said difference producing an increase of 1 millimetre or more in the length of a column of said liquid in the measurement tube when the temperature increases by 1°C.

Because the cross-section of the measurement tube is 1 mm or greater, and the liquid is visible in NMR images, the liquid in the measurement tube can be seen in NMR images, even in the case of whole body MRI. The length of a column of liquid in the measurement tube is indicative of the temperature, so the image of the liquid column provides an indication of the temperature at the time when the NMR image was acquired. This technique enables the temperature in the bore of the MRI apparatus to be read directly from the image of the MRI thermometer, without requiring significant computation.

Because there is a significant difference between the temperature coefficient(s) of expansion of the reservoir/measurement tube material compared to that of the liquid, there is a relatively large change in the length of the liquid column in the measurement tube for every degree of temperature change. This improves the accuracy of the temperature reading provided by evaluating the length of the liquid column in an NMR image.

A method of measuring the temperature in the bore of an MRI apparatus, the method comprising the steps of:

positioning the above-described MRI thermometer in the bore of the MRI apparatus;
operating the MRI apparatus to acquire NMR measurement data for generation of an image including an image of the MRI thermometer; and
evaluating the temperature in the MRI apparatus dependent on the length of liquid in the measurement tube in the image of the MRI thermometer.

According to the latter method the temperature measurement is made at the same time as the image is generated, not at the end of the measurement session when the subject exits the MRI apparatus. Accordingly, the temperature measurement made using the MRI thermometer is a more accurate indication of the environmental conditions when the image was acquired than a measurement made when the subject exits from the MRI apparatus. Furthermore this temperature-measurement method is simple and inexpensive to implement.

Further features and advantages of the present invention will become apparent from the following description of preferred embodiments thereof, given by way of example, and illustrated with reference to the drawings described hereinafter.

Brief Description of the Drawings

Fig.1 is a diagram that illustrates schematically the arrangement of an MRI apparatus used in an experiment implementing a method according to the first aspect of the present invention;
Fig.2 shows images generated using the experimental arrangement of Fig.1, in which:

Fig.2A shows a STIR image, and
Fig.2B shows a corresponding diffusion-weighted image;

Fig.3 illustrates the shape and use of a guide structure that may be used in an apparent-diffusion-coefficient evaluation method according to a first preferred embodiment of the invention, in which:

Fig.3A shows the guide structure, and
Fig.3B illustrates the positioning of the guide structure in relation to a subject being imaged;

Fig.4 is a flow diagram indicating steps in the method according to the first preferred embodiment;
Fig.5 illustrates MRI thermometers embodying a second aspect of the present invention, in which:

Fig.5A illustrates a first MRI thermometer, and

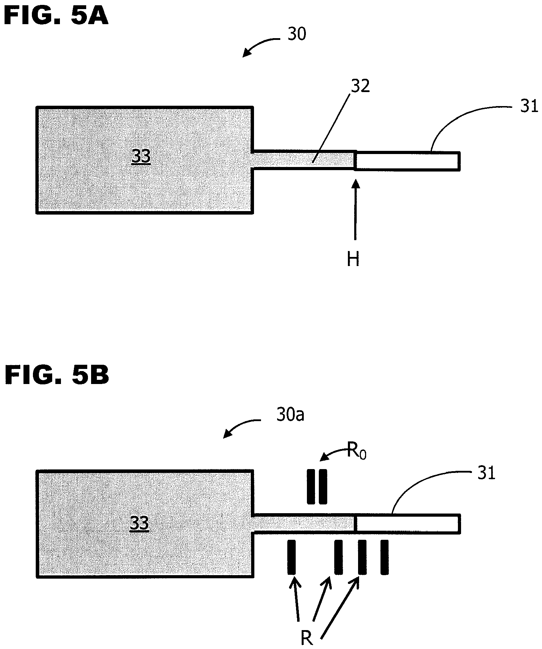

Fig.5A illustrates a variant of the first MRI thermometer;

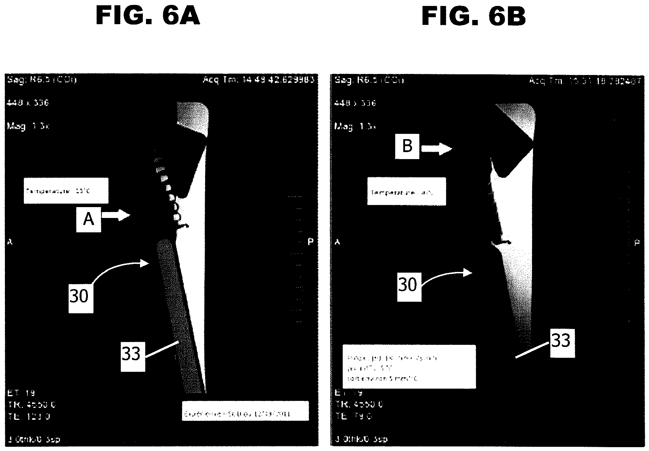

Fig.6 shows NMR images of the first MRI thermometer; and

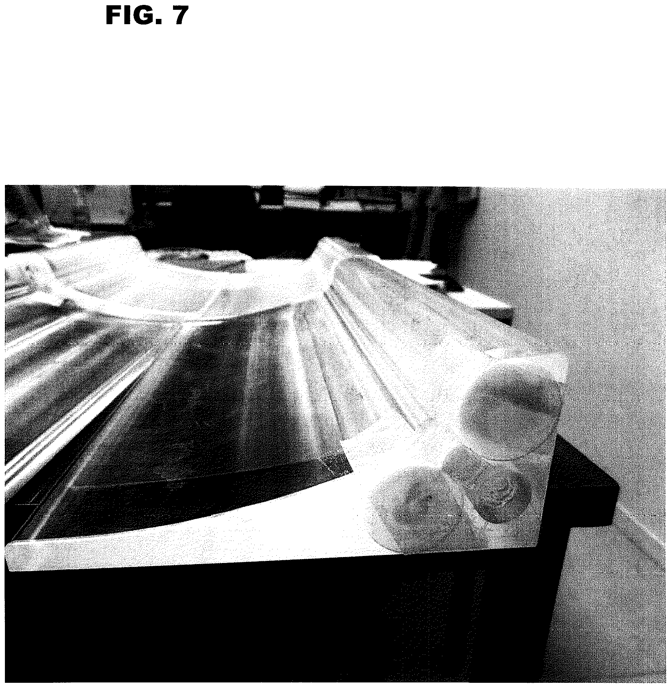

Fig.7 shows an integrated test structure and MRI thermometer.

Detailed Description of the Preferred Embodiments

The theory underlying the ADC-evaluation method provided by the first aspect of the present invention shall now be explained using, as an example, the case where the baseline measurement data is generated by applying a Short inversion Time Inversion Recovery (STIR) measurement sequence. It will be recalled that other magnetic resonance measurement sequences may be used to produce the baseline measurement data.

Existing clinical protocols often involve the control of MRI apparatus so as to acquire coronal STIR image data (as well as generating T1 image data, scout data etc.). The signal equation for a STIR sequence incorporating an inversion pulse can be expressed according to equation (4) below:

$$S_{STIR} = S_{0STIR} \left(1 - E^{-TI/T1} \left(2 - E^{-TR/T1}\right)\right) E^{-TE/T2} \qquad (4)$$

The inversion time TI, the echo time TE and repetition time TR will typically have the same values as those used for diffusion-weighted measurement sequences incorporating an inversion pulse. The value $S_{0STIR}$ is a constant which, although different from $S_{0DIFF}$, once again depends on experimental conditions.

The ADC-evaluation method of the invention involves generating respective sequences of baseline measurements (which may be, for example, STIR measurements) and diffusion-weighted measurements, with the set of control parameters - repetition time (TR), echo time (TE) and inversion time (TI) - taking approximately the same values in the two cases.

The baseline image (e.g. STIR image) and diffusion-weighted image need not be generated in the same plane/direction. However, the ADC of a region of interest is determined by extracting, from the STIR measurements (or other baseline measurements) and diffusion-weighted measurements, data that relates to the same region of interest. In view of the low signal to noise ratio of the diffusion signal it is necessary to handle a region containing more than one voxel, typically a region containing tens of voxels. For the region of interest it is possible to calculate the ratio $R_{DS}$ of the measurement signals from the diffusion-weighted and STIR data, as follows:

$$R_{DS} = \frac{S_{DIFF}}{S_{STIR}} = \frac{S_{0DIFF}}{S_{0STIR}} E^{-b\,ADC} = R_{DS0} E^{-b\,ADC} \qquad (5)$$

or, more generally, from the diffusion-weighted and baseline measurement data, as follows:

$$R_{DS} = \frac{S_{DIFF}}{S_{BASE}} = \frac{S_{0DIFF}}{S_{0BASE}} E^{-b\,ADC} = R_{DS0} E^{-b\,ADC} \qquad (5a)$$

where $S_{BASE}$ is the baseline measurement signal for the region of interest measured by application of a nuclear magnetic resonance sequence (whether this is a STIR sequence, a T2-weighted sequence, etc.) having the same type of acquisition as the diffusion-weighted sequence and $S_0$ BASE is a constant which depends on the experimental conditions during acquisition of the baseline measurement data.

The influence of relaxation times can be eliminated by setting the control parameters for the baseline and diffusion-weighted sequences - that is the values of the parameters TE, TI and TR - substantially equal to each other. It has been found that it is not essential to set the control parameters precisely equal to each other. For example, if the repetition time TR is sufficiently long compared to the relaxation times T1 of the tissues, notably 2 to 5 times as long, then somewhat different values of TR can be used in the diffusion-weighted sequence compare to the STIR sequence and this will have only a limited effect on the results.

Bearing in mind the fact that the b-value applied in the diffusion-weighted sequence is known, the ADC value of the region of interest can be evaluated based on equation (5) or (5a) if the ratio $R_{DS0}$ is known, notably using equation (6) below if the baseline measurement data is obtained by applying a STIR measurement sequence:

$$ADC = -\frac{1}{b}\ln\left[\frac{S_{DIFF}}{S_{STIR}} / R_{DS0}\right] \qquad (6)$$

or, more generally:

$$ADC = -\frac{1}{b}\ln\left[\frac{S_{DIFF}}{S_{BASE}} / R_{DS0}\right] \qquad (6a)$$

In the ADC-evaluation method of the invention, a value for the ratio $R_{DS0}$ is estimated based on the use of one or more reference samples (objects or substances) whose diffusion properties are known. In particular, for a reference sample placed in the measurement zone in close proximity to the subject being imaged, and having apparent diffusion coefficient ADCr, in the case where the baseline measurement data is obtained by applying a STIR measurement sequence:

$$R_{DS0} = \frac{Sref_{DIFF}}{E^{-b\,ADCr} \times S_{refSTIR}} \qquad (7)$$

where $Sref_{DIFF}$ is the signal measured for a region in the reference sample during the diffusion-weighted measurement sequence and $Sref_{STIR}$ is the signal measured for the same region in the reference sample during the STIR measurement sequence, or, more generally:

$$R_{DS0} = \frac{Sref_{DIFF}}{E^{-b\,ADCr} \times S_{refBASE}} \qquad (7a)$$

where $Sref_{BASE}$ is the signal measured for the same region in the reference sample during the baseline measurement sequence. Incidentally, it is advantageous to calculate the ratio $R_{DS0}$ using diffusion measurement data and baseline measurement data relating to the same region in the reference sample because the measurement signal has a strong dependence on the relative position of the measurement region with respect to the receive radio frequency coils.

The calculation of the ratio $R_{DS0}$ based on signals measured for a reference object is simpler if the reference object is a homogenous object whose properties - especially ADC - are approximately constant throughout its volume. In practice this can be achieved in a simple manner by making use of a reference object that consists of a volume of liquid, e.g. a bag of liquid, or a container filled with liquid.

In practice, it has been found to be preferable to use two or more reference samples placed in close proximity to the subject being imaged. This increases the robustness and accuracy of the method and compensates for the inherently low signal-to-noise ratio of diffusion images. On the other hand, the space inside the bore of an MRI apparatus is limited and the number/volume of the reference samples should be chosen so as not to restrict the patient's access.

When two or more reference samples are used, estimates of the ratio $R_{DS0}$ are calculated for points inside each of the reference samples based on $S_{DIFF}$ and $S_{BASE}$ values measured at those points and the known diffusion coefficients of the reference samples, by applying equation (7a). The individual ratio estimates can be processed to yield a single value for $R_{DS0}$ to use in applying (6a) above to map ADC values of biological tissue based on $S_{DIFF}$ and $S_{BASE}$ values measured at locations within the tissue. One technique for producing a single $R_{DS0}$ value based on the individual $R_{DS0}$ estimates calculated for different reference samples is to take a simple average of the individual estimates produced for the different reference samples. However, other techniques may be used for producing a single $R_{DS0}$ value based on the individual $R_{DS0}$ estimates calculated for different reference samples.

When two or more reference samples are used it is advantageous to employ reference samples whose ADCr values are relatively different from one another. For example, it can be advantageous to use a first reference sample having high mobility (e.g. a bag of pure water, whose diffusion coefficient is $2.4 \times 10^{-3}$ mm$^2$/second) and a second reference sample having relatively low mobility. It is advantageous to select reference samples whose different ADC values span the range of values that is expected to be encountered in healthy and pathological biological tissue.

Ideally, the reference sample(s) would be positioned inside the patient so as to be as close as possible to the tissue whose ADC is being measured. In practice, the reference sample(s) is/are placed close to, or in contact with, the patient's body in the vicinity of the tissue whose ADC is to be measured.

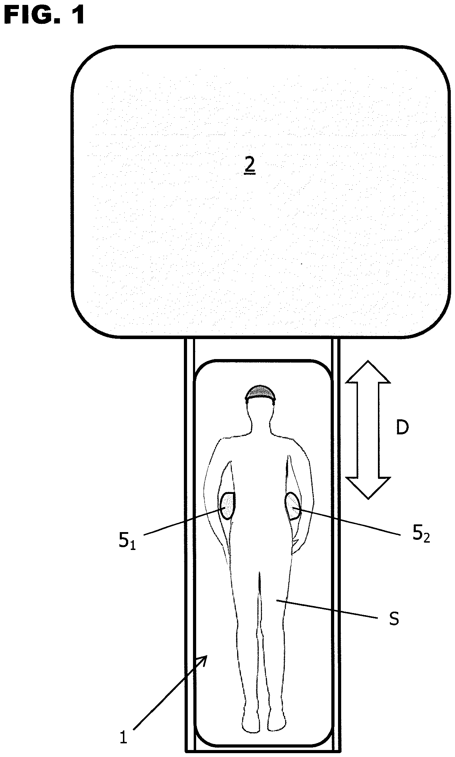

Fig.1 illustrates, schematically, an experimental arrangement that was used to test an ADC-evaluation method according to the first aspect of the present invention. As illustrated in Fig.1, a subject S (here a human patient), was asked to lie on the table 1 of an MRI apparatus 3. The table moved in the direction of the arrow D to introduce the subject S into the bore of the MTI apparatus 3 so that MRI measurements could be taken and to remove the subject from the apparatus 3 when the measurements had been completed.

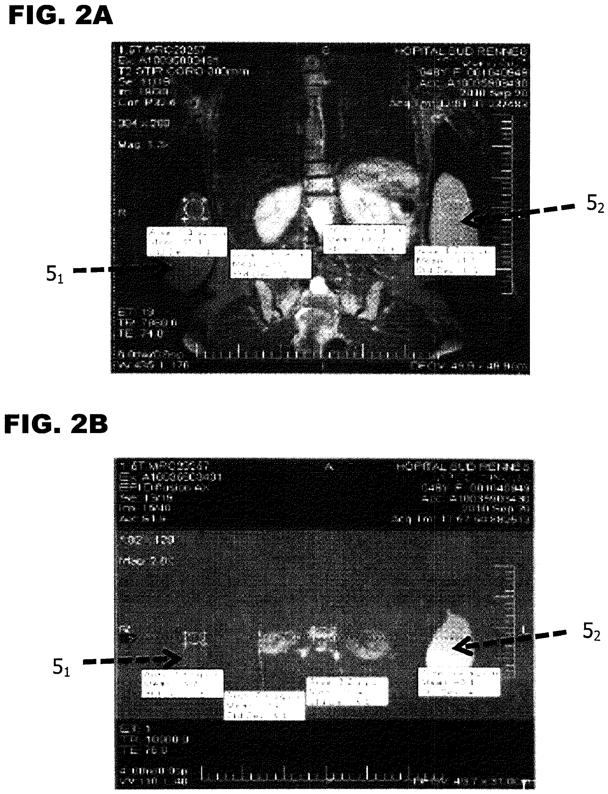

Two reference objects, $5_1$ and $5_2$ were arranged close to the subject S. The first reference object $5_1$ was a flexible bag of pure water (diffusion coefficient = $2.4 \times 10^{-3}$ mm$^2$/second) and the second reference object $5_2$ was a flexible bag containing a 25% polyethylene glycol (PEG) solution (diffusion coefficient = $0.7 \times 10^{-3}$ mm$^2$/second). The volume of each bag was approximately one litre. The bags were arranged at the subject's sides, roughly level with the kidneys.Fig.2 shows images that were produced by taking measurements on the subject S and the reference objects $5_1$ and $5_2$. Fig.2A shows a coronal STIR image corresponding to a region including the subject's pelvis and kidneys, and Fig.2B shows the corresponding region in an image generated from diffusion-weighted measurement data (acquired in an axial plane). The reference objects $5_1$ and $5_2$ are labelled in the two images.

In this example the reference objects $5_1$ and $5_2$ make use of flexible bags made from a material that is suitable to be brought into contact with the patient. The concentration of the PEG solution in reference object $5_2$ can be varied, notably in the range from 20-30%, to correspond to diffusion values that tend to characterize pathological restriction of diffusion. Moreover, the liquids in the reference objects are not limited to water and PEG solution but can be other liquids, preferably liquids which:

- have high proton concentration,
- have a T1 relaxation time different from that of fat (when the baseline measurement sequence is one such as STIR that incorporates fat suppression), and
- have a relatively long T2 relaxation time (when the baseline measurement sequence is one generated using long TE).

For example, when the measurement sequences are ones that do not involve suppression of the signal from fat, oils may be used as references.

It is not essential to make use of reference objects that consist of filled flexible bags; the reference samples may be presented in other forms. An example of a different form of reference object consists in an array of hollow optical fibres filled with water and all aligned along a common direction. A different diffusion coefficient applies in the direction along the length of the fibres (unrestricted diffusion) and in the direction across the width of the fibres (where the water movement is restricted by the fibre walls).

Apparent diffusion coefficient values were calculated for biological tissue in the subject S by estimating the value of $R_{DS0}$ using equation (7) and based on the $S_{DIFF}$ and $S_{STIR}$ values measured for the reference samples $5_1$ and $5_2$, together with the known values of the diffusion coefficients of water and the 25% PEG solution, and averaging the estimates produced for the reference samples $5_1$ and $5_2$; the resultant value was used to calculate ADC values using equation (6) above. This method yielded ADC values for the kidney region of the subject S that are well within the range of values expected for the ADC in human kidneys. Moreover, this method indicated that, in the case of the biological tissue shown in Fig.2, there was a restriction of diffusion in the vertebral body (ADC only equal to 47% that of water). This reduced ADC value could be interpreted by a clinician as an indication of the presence of a myeloma.

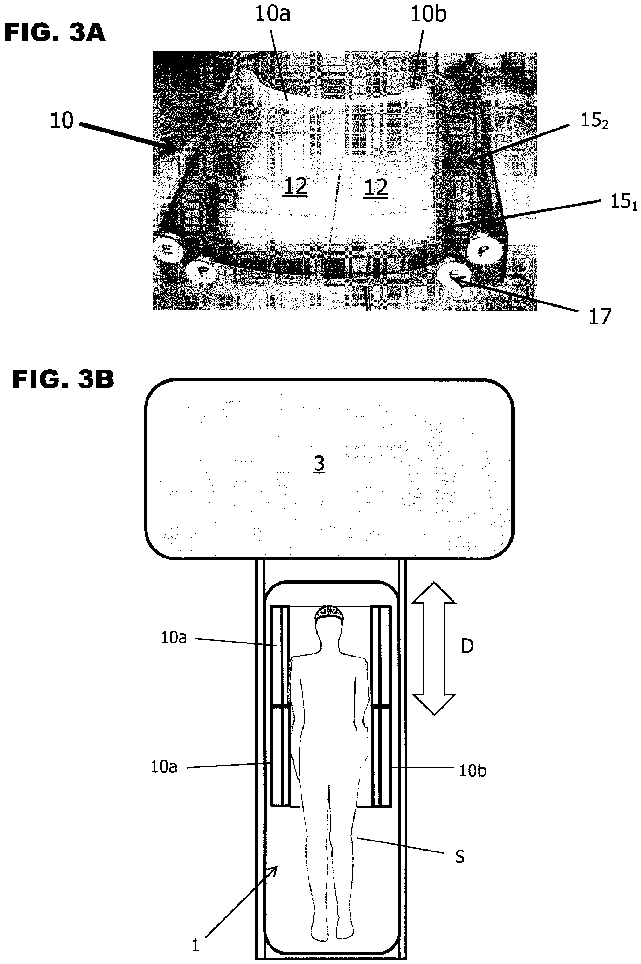

A first preferred embodiment of the ADC-evaluation method according to the invention will now be described with reference to Fig.3.

As illustrated in Fig.3A, the first preferred embodiment makes use of a guide structure 10 which includes tubular compartments $15_1$, $15_2$ for first and second reference liquids; the ends of the compartments $15_1$, $15_2$ have openings that are closed by close-fitting bungs 17. The guide structure 10 is made of a material that does not give an NMR signal and which is compatible with MRI (i.e. no metal), for example Plexiglas. In this example, the reference liquids are pure water and a PEG solution once again (and their diffusion coefficients are known).

The guide structure 10 is designed to be positioned under a subject who is going to be subjected to MRI, and the compartments $15_1$, $15_2$ are provided at the edges of the guide structure 10 so that the reference liquids will be positioned close to but outwardly of the subject S. This positioning can be more clearly understood from Fig.3B, which shows two guide structures 10 arranged end to end under a human subject.

In the specific example illustrated in Fig.3A, the guide structure 10 is formed in two parts 10a, 10b each of which has a generally wedge-shaped form including a relatively thick edge portion - where the compartments are provided for receiving the two reference liquids - and a relatively thinner, tapering portion 12 that is shaped and dimensioned to go under the back of a human subject. In this specific example, the height of each of the parts 10a, 10b at the thick edge portion thereof is 75mm, the length of each part is 400 mm and the width is 190mm. Because the guide structure 10 is formed in two parts 10a, 10b, it is possible to accommodate human subjects of different sizes (notably, different widths across the body). The guide structure 10 can be positioned on the table 1 before the subject S lies down.

Moreover, Fig.3B illustrates a case where whole-body MRI is being performed and two guide structures 10 are required to cover the full extent of the region being imaged; it will be understood that a different number of guide structures (one, three, etc.) may be used depending on the size of the region being imaged. Moreover, depending on the region being imaged it is not essential to position guide structure parts 10a and 10b on both sides of the patient, it may be sufficient to position one or more guide structure parts on a single side of the patient.

In this specific example, the guide structure 10 is provided with a sufficient number of compartments (four) to enable samples of both reference liquids to be positioned at both sides of the subject S. The advantage of positioning samples of both reference liquids (or, more generally, all of the reference substances/objects) in close proximity to each other is that this ensures that all of the samples are subjected to approximately the same environmental conditions (applied field, local temperature, etc.). The advantage of positioning samples of the reference liquids (or, more generally, all of the reference substances/objects) on both sides of the subject is that this helps to compensate for possible differences in the sensitivities of the receive radio frequency coils.

In this specific example, the guide structure 10 includes a first set of two compartments $15_1$, $15_2$ configured to be positioned at one side of a human subject S and a second set of compartments $15_1$, $15_2$ configured to be positioned at the other side of the subject S. As illustrated in Fig.3A it is advantageous to allocate reference samples to the compartments differently at the two sides of the subject S. In particular, although a water sample is placed in the lower compartment on the right-hand side of Fig.3A, a PEG sample is placed in the lower compartment on the left-hand side of Fig.3A. Similarly, although a PEG sample is placed in the upper compartment on the right-hand side of Fig.3A, a water sample is placed in the upper compartment on the left-hand side of Fig.3A. The advantage of this arrangement is that, once again, it helps to compensate for possible differences in the sensitivities of the receive radio frequency coils.

In this specific example, the tubular compartments $15_1$, $15_2$ are oriented with their axes lying approximately in the z-direction of the MRI apparatus (along the patient) and compartments are provided at different heights relative to the positioning portion 12, as well as at different positions in the y-direction of the MRI apparatus. The compartments $15_1$, $15_2$ could be configured to extend in a different direction, if appropriate in view of the region being imaged.

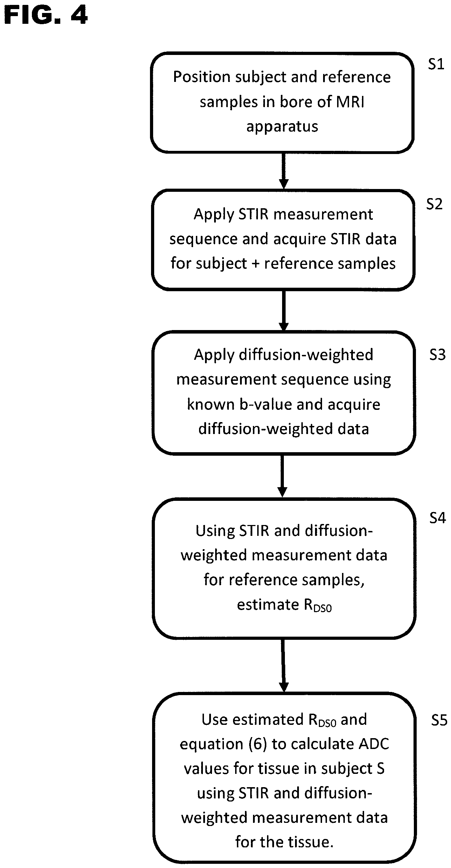

Fig.4 is a flow diagram illustrating the steps of the ADC-evaluation method according to the present embodiment of the invention.

As illustrated in Fig.4, a first step S1 of the ADC-evaluation method according to the present embodiment involves positioning the subject and the reference samples in the bore of the MRI apparatus 3. More particularly, in this example (and assuming a human subject), the guide structure 10 is positioned so that the positioning portions 12 are located under the subject's back, with the compartments $15_1$, $15_2$ extending along (and outwardly of) the subject's sides. A slide mechanism (not shown) of the table 1 of the MRI apparatus 3 is operated to position the subject and the reference samples inside the bore of the MRI apparatus 3.

In step S2 of the method the operating conditions of the MRI apparatus 3 are regulated so as to expose the subject and the reference samples to magnetic fields suitable to generate baseline measurement data (e.g. STIR image data) corresponding to at least a target region of the subject as well as the reference samples, and the baseline measurement data is captured. The manner in which the operating conditions of the MRI apparatus 3 should be adjusted in order to generate and capture STIR measurement data, T2-weighted measurement data, etc., as well as standard processing procedures for generating images based on different measurement sequences, are well-known in this field so no further detail is provided here.

In step S3 the operating conditions of the MRI apparatus 3 are regulated based on a known b-value so as to expose the subject and the reference samples to magnetic fields suitable to generate diffusion-weighted image data corresponding to at least the target region of the subject, as well as the reference samples, and the diffusion-weighted measurement data is captured. When the ADC calculation is based on two images (one conventional and one diffusion-weighted) then the b-value applicable to the baseline measurement data approximates to zero and the b-value used to generate the diffusion-weighted image is preferably large, notably close to 1.1/ADC the value of ADC used here being a target value at or near the centre of the range of ADC values that is expected to be encountered in the imaged tissue (bearing in mind the possibility that the imaged tissue may include unhealthy tissue, e.g. a tumour, as well as healthy tissue). Typically, the diffusion-weighted measurement data will be produced using a b-value in the range from approximately 300 to approximately 800 s/mm$^2$.

The manner in which the operating conditions of the MRI apparatus 3 should be adjusted in order to generate and capture diffusion-weighted measurement data are well-known in this field so no further detail is provided here. It is sufficient to mention that the times TI, TE and TR used in step S3 are set so as to be similar to the corresponding times TI, TE and TR used in step S2, within the tolerances mentioned above.

In step S4 the baseline and diffusion-weighted signals produced for the reference samples are analysed, taking into the account the diffusion coefficients of the reference samples and the b-value applied in step S3, so as to estimate values for the ratio $R_{DS0}$, using equation (7a) above. In the present example there are two reference substances arranged in four compartments. A first estimate of $R_{DS0}$ is produced by processing baseline and diffusion-weighted signals produced for at least one selected region in one or more of the compartments.

In step S5 ADC values are evaluated for different locations within the subject, using equation (6a) above, the baseline measurement data and diffusion-weighted measurement data acquired for the respective locations, and the $R_{DS0}$ ratio calculated in step S4.

The diffusion coefficient is highly sensitive to temperature variations (altering by an amount of approximately 2.4% per °C of temperature change). Accordingly, it is preferable to adjust the diffusion coefficients of the reference samples that are used in the calculations in step S4 so that these values accurately reflect the true diffusion coefficient values that were applicable at the time when the measurement data was generated. In order to be able to perform an appropriate temperature adjustment it is necessary to have an indication of the temperature in the bore of the MRI apparatus at the time when the measurement data was generated.

One possible approach consists in arranging a thermometer on the table of the MRI apparatus and making sure to read this thermometer when the subject comes out of the MRI apparatus. The temperature reading is considered to be an indication of the temperature in the bore of the MRI apparatus at the time when the STIR and diffusion-weighted measurement data was produced. The known diffusion coefficients of the reference samples are adjusted based on this temperature indication so as to use, for the calculation of $R_{DS0}$, diffusion coefficient values that apply to these reference substances at the indicated temperature.

However, measuring temperature in the bore by checking a thermometer after the measurement session ends is cumbersome and produces errors: it is necessary to remember to take the temperature reading at the end of the measurement session and the temperature at the end of the session may not be an accurate indication of the temperature in the bore of the MRI apparatus at the time when the measurement data was acquired.

A second aspect of the invention provides an MRI thermometer. The MRI thermometer can be positioned in the MRI apparatus in proximity to the subject being imaged and is specifically designed to show up in MRI images (irrespective of whether they are STIR images, T1-weighted images, etc.).

According to the second aspect of the invention the MRI thermometer includes a reservoir that is in communication with a measurement tube; a selected liquid is provided in the reservoir and, as the temperature increases, a column of the liquid expands along the measurement tube. The length of the liquid column in the measurement tube is indicative of the temperature. In order for the MRI image of the MRI thermometer to provide a reading that is measurable from the MR image it is necessary for a number of conditions to be fulfilled:

a) the measurement tube needs to have an internal cross-section that is sufficiently large to ensure that the tube (or, more accurately, the liquid in the tube) is visible in an MRI image;

b) the measurement tube should be made of a material that is invisible or barely visible in MRI images (or else it will mask the liquid column), and the material must be compatible with MRI - i.e. no metal; these conditions are fulfilled by making the measurement tube of glass;

c) the liquid should be a substance that shows up in NMR images, ethanol contains protons and so is a suitable substance, other suitable substances include other alcohols, ethers, acetone, etc.;

d) the length of the liquid column in the measurement tube must change to an extent that is visible in an NMR image as the temperature changes, notably, in the case of whole-body MR imaging it is advisable to ensure a length-change of at least 1mm (and, preferably, greater than 2 mm) for every 1°C change in temperature;

e) in order to obtain the large length-change mentioned at d) above in a measurement tube of the size specified at a) above it is necessary to have a large difference in the temperature coefficient of expansion of the container (i.e. the reservoir and the measurement tube) compared to that of the liquid, this favours the use of container material that has a low temperature coefficient of expansion (the lower the better) and the use of a liquid that has a relatively high temperature coefficient of expansion - once again glass and alcohol are suitable materials to fulfil these conditions for the container and the liquid, respectively, and glasses having a low temperature coefficient of expansion (e.g. borosilicate glasses) are particularly advantageous; and

f) moreover, in order to accommodate the large expansion of the liquid as temperature increases (as mentioned at d) above) it is necessary to use a reservoir of relatively large capacity.

There is an interplay between various of the factors mentioned above. For example, a large internal diameter of the measurement tube makes it easier to see the liquid column in the MRI image. However, if the diameter of the measurement tube is increased then the change in length of the liquid column that will be observed for a given change in temperature will reduce, tending to lower the resolution of the temperature measurement. In practice, in the case of an MRI thermometer that is to be used in whole body MRI it is desirable to set the diameter of the measurement tube in the range of approximately 1 mm to approximately 1 cm.

If the MRI thermometer is intended for use in imaging the wrist or knee (where field of view is about 10-15 cm), or the head (where field of view is 20-25 cm), the typical image resolution is about 0.5 mm so it is acceptable to use a measurement tube whose internal diameter is approximately 1 to 2 mm; however in the case of imaging the spine or abdomen a larger field of view must be accommodated (e.g. 50 cm) and the image resolution is about 1-2 mm so it is preferable to use a measurement tube whose internal diameter is 2 mm or more; the upper limit on the internal diameter of the measurement tube is 1cm (although this would require a very large reservoir).

In case it is thought that an MRI thermometer of the type proposed in the present application is comparable to a conventional alcohol thermometer it should be mentioned that the capillary of a conventional alcohol thermometer is generally small, e.g. 0.3 mm. Moreover, a MRI thermometer according to the invention can make use of ethanol (and other transparent liquids) without the colorants that are usually added to the measurement liquid to improve the readability of known alcohol thermometers.

As indicated above, for a given liquid in the thermometer the choice of diameter for the measurement tube affects the amount by which the length of the liquid column changes for each degree of temperature change, and large length change improves the resolution of the thermometer. However, once again, when choosing the liquid for the thermometer a compromise must be achieved between the desire to choose a liquid having a thermal coefficient of expansion large enough to produce a large length change per degree change in temperature given the dimensions of the measurement tube and, firstly, the need to ensure that the size of reservoir needed to contain the liquid will not be undesirably large and, secondly, the need to achieve a satisfactory temperature range (Tmin-Tmax) that can be measured using this thermometer, without unduly increasing the length of the measurement tube.

Consider a measurement liquid having thermal coefficient of expansion $\beta$, where $\beta = dV/V$ per °C, and V is the total volume of liquid whereas dV is the change in volume for one degree C increase in temperature. Let us approximate the total liquid volume V by the volume Vr of the reservoir of the MRI thermometer, ignoring the volume of liquid in the measurement tube. The thermal expansion of the material(s) forming the reservoir and the measurement tube shall also be ignored. (These approximations do not affect the validity of the conclusions drawn below). When some measurement liquid is already present in the measurement tube, the length of the liquid column in the measurement tube will increase by an amount dL (mm) when the temperature increases by 1°C. Assuming that the measurement tube has an internal diameter of D, the following relationships apply:

$$dV = \pi \, (D/2)^2 \, dL$$

$$dV \approx \beta \, Vr, \qquad\qquad \text{so}$$

$$Vr \approx (\pi \, (D/2)^2 \, dL) \, / \, \beta \qquad\qquad (8)$$

It will be understood from equation (8) above that the volume of the reservoir, Vr, increases as the amount dL that the liquid column changes per °C increases. Similarly, the required size of the reservoir depends heavily on the diameter of the measurement tube.

As an example, assuming that the measurement liquid is ethanol having $\beta = 750 \times 10^{-6}$/°C, the internal diameter of the measurement tube is 3 mm and it is desired to have a change in length of 5mm for each degree of temperature change, it would be necessary to provide a reservoir of volume approximately 47 000 mm$^3$. If the reservoir had a generally cylindrical shape this volume could be achieved, for example, by setting the length of the reservoir to approximately 80mm and the diameter to approximately 27.2 mm. Moreover, if it were desired to be able to measure temperatures in the range from 15°C to 30°C with this example of thermometer then the measurement tube would need to be at least 75 mm long (15°C x 5mm/°C).

The target amount of displacement of the end of the liquid column depends on the spatial resolution of the MR images and the desired temperature resolution. In general, the minimum displacement that is liable to be measureable in the image is a displacement of about twice the spatial resolution of the image. Thus, for example, in the case of whole-body MRI where the spatial resolution of the image tends to be 2 mm/pixel, if it is desired to have a temperature resolution of 1°C then the target displacement of the liquid per °C change in temperature is 4mm (and the internal diameter of the measurement tube is typically 3 mm). in another example, for brain imaging the spatial resolution tends to be 1mm or better, so the displacement of the liquid column may be reduced to 2mm/°C and the diameter of the tube can also be reduced (see above); this has the advantage of reducing thermal inertia.

A first embodiment of MRI thermometer 30 is illustrated, diagrammatically, in Fig.5A.

As shown in Fig.5A, the MRI thermometer 30 includes a glass reservoir 33 in communication with a glass measurement tube 31. In a working example of this embodiment the reservoir 33 was generally cylindrical with a diameter of 20 mm and a length of 160mm, corresponding to a volume of approximately 50250 mm$^3$. In the working example the measurement tube had a circular cross-section of internal diameter 3 mm, and was approximately 120mm long. It is not essential to use a reservoir and measurement tube that have circular cross-section; other shapes can be used. The thickness of the walls of the measurement tube is not particularly limited and is set so as to ensure the required mechanical resistance; a typical value is 1 to 2 mm thick.

In the working example, the liquid 32 provided in the reservoir 33 and measurement tube 31 was ethanol, which has a large thermal expansion coefficient. In the embodiment illustrated in Fig.5A the quantity of ethanol provided in the reservoir and measurement tube was sufficient to produce a liquid column that extended halfway along the measurement tube 31 at a temperature of 24°C (i.e. at the point labelled H in Fig.5A). Moreover, the temperature coefficients of expansion of the glass forming the reservoir 33 and measurement tube 31 was sufficiently different from the temperature coefficient of expansion of the alcohol 32 that, in the working example, the liquid column in the measurement tube 31 underwent a 5mm change in length for every °C change in temperature.

Fig.6 shows turbo spin echo NMR images that were produced when an MRI thermometer according to the above-described working example based on Fig.5A was arranged in the bore of an MRI apparatus. Incidentally, in the images of Figs.6A and 6B a bright, generally wedge-shaped element is visible adjacent to the MRI thermometer; this wedge-shaped element was present merely for positioning purposes during the test and does not form part of the thermometer itself.

Fig.6A is an NMR image acquired when the temperature in the bore of the MRI apparatus was 15°C whereas Fig.6B is an NMR image produced using corresponding operating conditions but when the temperature in the bore of the MRI apparatus was 30°C. Arrows A and B in Figs.6A and 6B indicate the respective positions of the end of the liquid column in the measurement tube 31 in each case. Not only is the MRI thermometer clearly visible in both images but also a change in the length of the liquid column in the measurement tube can be clearly seen from Fig.6A to Fig.6B.

Fig.5B illustrates a variant 30a of the MRI thermometer illustrated in Fig.5A. the variant makes use of index bars R and R0 to facilitate the reading of temperature from an NMR image of the thermometer 30a. Each index bar is made of or contains a material having protons available to precess in a magnetic field, such as a small tube filled with water. In a working example, each bar was 10 mm long, 5mm in depth and 3mm wide and the bars were glued to the measurement tube. In this working example, the pair of index bars R0 corresponds to the position reached by the end of the liquid column when the temperature is 20°C, whereas the other index bars R indicate steps of 2°C. In other words, the index bar R to the left of the pair of bars R0 in Fig.5B corresponds to the position of the end of the liquid column when the temperature is 18°C, and the temperature indicated in Fig.5B is just below 24°C. In practice it is necessary to calibrate the thermometer 30a so that the relationship between the spacing of the index marks and the change in temperature is known.

MRI thermometers according to the second aspect of the invention make it possible to determine in a simple and inexpensive manner what the temperature was in the bore of the MRI apparatus when given NMR image data was acquired, by analysis of the image. These MRI thermometers can be used to provide an indication of temperature in the methods according to the first aspect of the invention - enabling the diffusion coefficients of the reference samples to be adjusted before the ratio $R_{DS0}$ is calculated - but can also be used more generally whenever it is desired to know the temperature in the bore of an MRI apparatus (e.g. for quality control purposes).

Although the invention has been described, in its various aspects, with reference to certain preferred embodiments it is to be understood that various modifications and improvements can be made without departing from the scope of the invention as defined in the appended claims.

For example, the mount structure 10 shown in Fig.3A may be modified so as to carry an MRI thermometer of the type illustrated in Figs.5A and 5B. An example of an integrated test structure and MRI thermometer is illustrated in Fig.7

Furthermore, although the specific embodiments described above relate to the case where ADC is evaluated based on combining measurement data from one baseline sequence with measurement data from one diffusion-weighted sequence, it is to be understood that the invention can be applied to enable ADC to be calculated based on combining measurement data from one baseline sequence with measurement data from two or diffusion-weighted sequences having different b values (although the time saving achieved through use of the invention is proportionately smaller).

## Claims

1. A method of evaluating the apparent diffusion coefficient of a region in biological tissue, the apparent diffusion coefficient being indicative of the rate of diffusion of a predetermined nucleus of interest in said region, comprising the steps of:

   introducing into the bore of a magnetic resonance apparatus: said biological tissue, and at least one reference sample having a known diffusion coefficient (ADCr) of said predetermined nucleus of interest;
   generating baseline measurement data by applying a nuclear magnetic resonance measurement sequence to said region in the biological tissue and to the reference sample(s);
   generating diffusion-weighted measurement data by applying a diffusion-weighted nuclear magnetic resonance measurement sequence having a known non-zero b value to said region in the biological tissue and to the reference sample(s);
   estimating a first ratio ($R_{DS0}$) based on the ratio between diffusion-weighted measurement data ($Sref_{DIFF}$) measured for said reference sample(s) and baseline measurement data ($Sref_{BASE}$) measured for said reference sample(s), on the b-value applied during generation of the diffusion-weighted measurement data, and on the known diffusion coefficient (ADCr) of the reference substance; and
   calculating the apparent diffusion coefficient of said region in biological tissue based on the ratio between diffusion-weighted measurement data ($S_{DIFF}$) measured for said region and baseline measurement data ($Sref_{BASE}$) measured for said region, on the b-value applied during generation of the diffusion-weighted measurement data, and on the estimated first ratio.

2. The apparent-diffusion-coefficient evaluating method according to claim 1, wherein the first ratio is estimated using equation (7a) below

$$R_{DS0} = \frac{Sref_{DIFF}}{E^{-b\,ADCr} \times S_{refBASE}} \qquad (7a)$$

where $Sref_{DIFF}$ represents said diffusion-weighted measurement data measured for a region in the reference sample(s), $Sref_{BASE}$ represents said baseline measurement data measured for the same region in the said reference sample(s), b is the b-value applied in the step of generating the diffusion-weighted measurement data, and ADCr is the diffusion coefficient of the reference substance.

3. The apparent-diffusion-coefficient evaluating method according to claim 1 or 2, wherein the apparent diffusion coefficient of said region in biological tissue is calculated using equation (6a) below:

$$ADC = -\frac{1}{b}\ln\left[\frac{S_{DIFF}}{S_{BASE}}/R_{DS0}\right] \qquad (6a)$$

where $S_{DIFF}$ represents said diffusion-weighted measurement data measured for the region of tissue, $S_{BASE}$ represents said baseline measurement data measured for said region of tissue, b is the b-value applied in the step of generating the diffusion-weighted measurement data, and $R_{DS0}$ is the estimated first ratio.

4. The apparent-diffusion-coefficient evaluating method according to claim 1, 2 or 3, wherein at least two reference samples having known and different diffusion coefficients of said predetermined nucleus of interest are introduced into the bore of the MRI apparatus with said tissue, and baseline measurement data and diffusion-weighted measurement data is generated for each of the at least two reference samples, wherein individual preliminary estimates of the first ratio are calculated based on measurement data for each of the reference samples, and the estimate of the first ratio is produced by combining the individual preliminary estimates.

5. The apparent-diffusion-coefficient evaluating method according to any one of claims 1 to 4, wherein the step of generating baseline measurement data comprises applying a measurement sequence selected in the group consisting of: a short inversion time inversion recovery (STIR) measurement sequence, a T2-weighted measurement sequence, a T2*-weighted measurement sequence, a proton-density-weighted measurement sequence, a T1-weighted measurement sequence, a TSE-weighted measurement sequence, a fast gradient echo sequence, and a Steady State Free Precession (SSFP) sequence.

6. The apparent-diffusion-coefficient evaluating method according to any one of claims 1 to 5, wherein in the step of generating baseline measurement data the values of the echo time (TE), and repetition time (TR), and inversion time (TI) if there is an inversion pulse, are set substantially the same as the respective values applied in the step of generating diffusion-weighted measurement data.

7. The apparent-diffusion-coefficient evaluating method according to any one of claims 1 to 6, wherein the biological tissue forms part of a subject (S) and the at least one reference sample is contained in a guide structure (10) comprising a portion (12) that is arranged between a body part of the subject (S) and a table (1) of the MRI apparatus when the subject (S) and the reference sample(s) is/are introduced into the MRI apparatus (3), thereby to position the reference sample(s) relative to the subject (S).

8. The apparent-diffusion-coefficient evaluating method according to claim 7, wherein the guide structure (10) comprises compartments ($15_1$, $15_2$) configured to receive the reference samples, and the guide structure (10) is configured to position at least one compartment at either side of the subject (S) when the body-part fitting portion (12) is arranged in contact with said body part.

9. The apparent-diffusion-coefficient evaluating method according to claim 7 or 8, wherein the guide structure (10) comprises a first set of compartments ($15_1$, $15_2$) configured to be positioned at one side of the subject (S) when the body-part fitting portion (12) is arranged in contact with said body part, and a second set of compartments ($15_1$, $15_2$) configured to be positioned at the other side of the subject (S) when the body-part fitting portion (12) is arranged in contact with said body part, the first set of compartments contains the same reference samples as the second set of compartments, but the allocation of reference samples to compartments is different between the first and second sets of compartments.

10. The apparent-diffusion-coefficient evaluating method according to any previous claim, and comprising the step of making a temperature-adjustment to the known diffusion coefficient(s) of the reference sample(s) based on a measurement of the temperature in the MRI apparatus, wherein the step of estimating the first ratio ($R_{DS0}$) employs the temperature-adjusted diffusion coefficient(s).

11. The apparent-diffusion-coefficient evaluating method according to claim 10, wherein an MRI thermometer (30) is introduced into the bore of the MRI apparatus (3) with said tissue, the MRI thermometer (30) comprising:

a reservoir (33) in communication with a measurement tube (31), the measurement tube (31) being made of a material that is substantially transparent in MRI images; and
a liquid (32) provided at least in the reservoir (33) and configured to expand along the measurement tube (31) as temperature increases, the liquid (32) being visible in MRI images;
wherein:

the internal cross-section of the measurement tube (31) is in the range of approximately 1 mm to approximately 1 cm,
there is a difference in thermal coefficient of expansion between the liquid (32) and the material(s) of the reservoir (33) and measurement tube (31), said difference producing an increase of 1 millimetre or more in the length of a column of said liquid (32) in the measurement tube when the temperature increases by 1°C; and
there is provided the step of measuring said temperature in the MRI apparatus (33) by evaluating in an NMR image the length of the column of liquid (32) in the measurement tube (31) of the MRI thermometer.

12. A guide structure (10) comprising:

at least one compartment (15) for receiving a reference sample having a known diffusion coefficient of a predetermined liquid, and
a positioning portion (12) configured to lie between a body part of a human subject (S) and a table (1) of an MRI apparatus on which the subject (S) lies, thereby to position the reference sample(s) relative to the subject (S).

13. The guide structure (10) according to claim 12, wherein the guide structure is formed of two parts (10a,10b) and the positioning portion (12) comprises tapering portions provided in each of the parts (10a,10b).

14. An MRI thermometer (30) comprising:

a reservoir (33) in communication with a measurement tube (31), the measurement tube (31) being made of a material that is substantially transparent in nuclear magnetic resonance (NMR) images; and
a liquid (32) provided at least in the reservoir (33) and configured to expand along the measurement tube (31) as temperature increases, the liquid (32) being opaque in NMR images;
wherein:

the cross-section of the measurement tube (31) is in the range of approximately 1 mm to approximately 1 cm; and
there is a difference in temperature coefficient of expansion between the liquid (32) and the material(s) of the reservoir (33) and measurement tube (31), said difference producing an increase of 1 millimetre or more in the length of a column of said liquid (32) in the measurement tube (31) when the temperature increases by 1°C.

15. A method of measuring the temperature in the bore of an MRI apparatus (3), the method comprising the steps of:

positioning in the bore of the MRI apparatus (3) an MRI thermometer (30) according to claim 14;
operating the MRI apparatus to acquire NMR measurement data for generation of an image including an image of the MRI thermometer (30); and
evaluating the temperature in the MRI apparatus (3) dependent on the length of liquid (32) in the measurement tube (31) in the image of the MRI thermometer (30).

# FIG. 1

## FIG. 2A

## FIG. 2B

**FIG. 3A**

**FIG. 3B**

# FIG. 4

Position subject and reference
samples in bore of MRI
apparatus — S1

Apply STIR measurement
sequence and acquire STIR data
for subject + reference samples — S2

Apply diffusion-weighted
measurement sequence using
known b-value and acquire
diffusion-weighted data — S3

Using STIR and diffusion-
weighted measurement data
for reference samples,
estimate $R_{DS0}$ — S4

Use estimated $R_{DS0}$ and
equation (6) to calculate ADC
values for tissue in subject S
using STIR and diffusion-
weighted measurement data
for the tissue. — S5

## FIG. 5A

## FIG. 5B

# FIG. 6A

# FIG. 6B

FIG. 7

Europäisches
Patentamt

European
Patent Office

Office européen
des brevets

# EUROPEAN SEARCH REPORT

Application Number

EP 12 30 5190

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BROCKSTEDT S ET AL: "QUANTITATIVE DIFFUSION COEFFICIENT MAPS USING FAST SPIN-ECHO MRI", MAGNETIC RESONANCE IN MEDICINE, ACADEMIC PRESS, DULUTH, MN, US, vol. 16, no. 8, 1 January 1998 (1998-01-01), pages 877-886, XP000878655, ISSN: 0740-3194 * page 878 - page 881; figure 1; tables 1,2 * | 1-6 | INV. G01R33/30 G01R33/48 G01R33/56 G01R33/563 |
| X | ONG H ET AL: "A new approach for simultaneous measurement of ADC and T2 from echoes generated via multiple coherence transfer pathways", JOURNAL OF MAGNETIC RESONANCE, ACADEMIC PRESS, ORLANDO, FL, US, vol. 173, no. 1, 1 March 2005 (2005-03-01), pages 153-159, XP004739005, ISSN: 1090-7807, DOI: 10.1016/J.JMR.2004.11.030 * page 154, column 1, paragraph 4 - page 156; table 1 * | 1-6 | |
| | | | TECHNICAL FIELDS SEARCHED (IPC) |
| | | | G01R |
| X | ALLEN W. SONG ET AL: "Single-shot ADC imaging for fMRI", MAGNETIC RESONANCE IN MEDICINE, vol. 57, no. 2, 1 January 2007 (2007-01-01), pages 417-422, XP055029892, ISSN: 0740-3194, DOI: 10.1002/mrm.21135 * page 417 - page 419 * | 1-6 | |

-/--

~~The present search report has been drawn up for all claims~~

| Place of search | Date of completion of the search | Examiner |
|---|---|---|
| Munich | 27 September 2012 | Raguin, Guy |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

EP 2 629 110 A1

Europäisches
Patentamt
European
Patent Office
Office européen
des brevets

**EUROPEAN SEARCH REPORT**

Application Number

EP 12 30 5190

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SANG OK PARK ET AL: "Relative apparent diffusion coefficient: Determination of reference site and validation of benefit for detecting metastatic lymph nodes in uterine cervical cancer", JOURNAL OF MAGNETIC RESONANCE IMAGING, vol. 29, no. 2, 22 January 2009 (2009-01-22), pages 383-390, XP055029749, ISSN: 1053-1807, DOI: 10.1002/jmri.21635 * page 384, column 2, paragraph 2 - page 385, column 1, paragraph 1 * ----- | 1-6 | |
| X | PADHANI A R ET AL: "Diffusion-weighted magnetic resonance imaging as a cancer biomarker: Consensus and recommendations", NEOPLASIA, NEOPLASIA PRESS, ANN ARBOR, MI, US, vol. 11, no. 2, 1 February 2009 (2009-02-01), pages 102-125, XP007913484, ISSN: 1522-8002, DOI: 10.1593/NEO.81328 * page 112 - page 113 * * page 120, column 2, paragraph 3 - page 122 * ----- | 1-6 | TECHNICAL FIELDS SEARCHED (IPC) |

~~The present search report has been drawn up for all claims~~

| Place of search | Date of completion of the search | Examiner |
|---|---|---|
| Munich | 27 September 2012 | Raguin, Guy |

EPO FORM 1503 03.82 (P04C01)

Europäisches
Patentamt

European
Patent Office

Office européen
des brevets

**Application Number**

EP 12 30 5190

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

[X] None of the further search fees have been paid within the fixed time limit. The present European search report has been drawn up for those parts of the European patent application which relate to the invention first mentioned in the claims, namely claims:

1-6

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**
**SHEET B**

Application Number

EP 12 30 5190

The Search Division considers that the present European patent application does not comply with the requirements of unity of invention and relates to several inventions or groups of inventions, namely:

1. claims: 1-6

   NMR method of evaluating an apparent diffusion coefficient of a region in biological tissue using at least one reference sample having a known diffusion coefficient
   ---

2. claims: 7-9, 12, 13

   Guide structure comprising at least one compartment for receiving a reference sample having a known diffusion coefficient, and NMR method of evaluating an apparent diffusion coefficient of a region in biological tissue that is part of a subject using said guide structure
   ---

3. claims: 10, 11, 14, 15

   MRI thermometer, method of measuring the temperature in the bore of an MRI apparatus using said MRI thermometer, and NMR method of evaluating an apparent diffusion coefficient of a region in biological tissue using at least one reference sample having a known diffusion coefficient comprising measuring the temperature in the MRI apparatus using said MRI thermometer and making a temperature-adjustment to the known diffusion coefficient of the reference sample
   ---